# EUROPEAN PATENT APPLICATION

(11) **EP 4 057 325 A1**
(43) Date of publication of application: **14.09.2022**
(21) Application number: 20883714.6
(22) Date of filing: 27.07.2020
(51) Int. Cl.: H01L 21/677

(54) **TRANSPORT VEHICLE SYSTEM**

(30) Priority: 05.11.2019 JP 2019200737
(71) Applicant: Murata Machinery, Ltd., Kyoto-shi, Kyoto 601-8326 (JP)
(72) Inventor: MOTOORI, Yoichi, Inuyama-shi, Aichi 484-8502 (JP)
(74) Representative: Hoffmann Eitle
(86) International application number: PCT/JP2020/028768
(87) International publication number: WO 2021/090542

(57) **Abstract**

An overhead transport vehicle system includes a travel rail, an overhead transport vehicle, and a gas supply device. The overhead transport vehicle travels on the travel rail to transport a FOUP, includes a tank to store inactive gas, and supplies the inactive gas into the F OUP from the tank during transport of the FOUP. The gas supply device is provided along the travel rail and supplies inactive gas into the tank of the overhead transport vehicle.

## Description

### Technical Field

The disclosure relates to a transport vehicle system.

### Background Art

In order to prevent oxidation of semiconductor substrates in the process of semiconductor production, a system (N2 purge) that injects nitrogen gas into a container such as a FOUP (Front Opening Unified Pod) accommodating semiconductor substrates to remove oxygen from the container is known.

Patent Literature 1 discloses an article transport equipment provided with a nitrogen gas supply device to supply nitrogen gas into a FOUP held by an overhead transport vehicle. The nitrogen gas supply device is provided at the position along a travel route of the overhead transport vehicle.

Patent Literature 2 discloses a configuration in which a nitrogen gas cylinder is provided at a transport vehicle (AGV) to transport an article such as a semiconductor device. The nitrogen gas cylinder stores nitrogen gas to be supplied into an article storage room in the transport vehicle.

### Citation List

### Patent Literature

Patent Literature 1: Japanese Unexamined Patent Application Publication No. 2016-96192
Patent Literature 2: Japanese Unexamined Patent Application Publication No. Sho 61-196856

### Summary of Invention

### Technical Problem

With the article transport equipment according to Patent Literature 1, nitrogen gas can be supplied into the FOUP held by the overhead transport vehicle only at a gas supply position where the nitrogen gas supply device is located. With this configuration, if the overhead transport vehicle travels for a long time, the nitrogen gas in the FOUP gradually decrease while the overhead transport vehicle travels and this may lead to oxidation of semiconductor substrates contained in the FOUP. With the configuration according to Patent Literature 2, nitrogen gas can be supplied into the storage room from the nitrogen gas cylinder while a transport vehicle transports an article, however, periodic operations such as exchange of the nitrogen gas cylinder are required to prevent the nitrogen gas cylinder from running out of nitrogen gas.

An aspect of the present disclosure provides a transport vehicle system capable of efficiently maintaining supply of inactive gas into a container being transported.

### Solution to Problem

A transport vehicle system according to an aspect of the present disclosure includes a rail, and a transport vehicle traveling on the rail to transport a container, the transport vehicle that includes a storage storing inactive gas and supplies the inactive gas from the storage into the container being transported, and a gas supply device provided along the rail and supplying the inactive gas into the storage of the transport vehicle.

In the above transport vehicle system, the transport vehicle includes a storage to supply the inactive gas into the container being transported, thus enabling the inactive gas to be consecutively supplied into the container being transported and keeping the container appropriately filled with the inactive gas. Further, in the above transport vehicle system, the gas supply device configured to supply the inactive gas into the storage is provided along the rail on which the transport vehicle travels, thus allowing the inactive gas to be supplied (supplemented) easily and appropriately into the storage included in the transport vehicle. For example, the transport vehicle travels along the rail to a position (gas supply position) where the gas supply device is located and supplements the inactive gas before the storage runs out of the inactive gas, thereby keeping the inactive gas stored in the storage in an appropriate manner. Therefore, according to the above transport vehicle system, the supply of inactive gas into the container being transported can be efficiently maintained.

The above transport vehicle system may further include a controller that monitors conditions of the inactive gas stored in the storage and judges whether supply of the inactive gas into the storage is required or not on a basis of the conditions of the inactive gas stored in the storage, the controller that controls the transport vehicle to travel up to a position where the gas supply device is located if supply of the inactive gas is determined to be required. According to the above configuration, monitoring conditions of the inactive gas stored in the storage and supplementing the inactive gas into the storage can be automatized by the controller. As a result, the storage of the transport vehicle can be prevented appropriately from running out of the inactive gas.

The transport vehicle may include a gas supply tube, a nozzle, and a support table. The gas supply tube is connected with the storage to circulate the inactive gas. The nozzle is provided at an end portion of the gas supply tube and connected to an inlet provided on a bottom of the container to supply the inactive gas into the container. The support table supports the bottom of the container and is capable of fixing the nozzle at a position corresponding to the inlet of the container. According to the above configuration, the container is supported by the support table and load of the container is applied to the support table, so that the inlet of the container and the nozzle fixed on the support table can be closely connected. With this configuration, the inactive gas in the storage can be stably supplied into the container via the gas supply tube, the nozzle, and the inlet.

The transport vehicle further may include a body into which the container is stored during transport of the container and a lift mechanism which is capable of suspending the container and moves vertically with respect to the body. The support table may be capable of retreating to a retreat position that prevents the support table from interfering with the lift mechanism or the container suspended by the lift mechanism at least when vertical operations are performed by the lift mechanism. According to the above configuration, the support table is capable of retreating to the retreat position, so that container transferring (loading and unloading) operations involving vertical operations performed by the lift mechanism can be performed appropriately.

The transport vehicle configures to make the lift mechanism grip and lift up the container to store the container into the body in a state where the support table is retreated to the retreat position, to cause the support table to be placed under the container from the retreat position after the container is stored into the body, and to make the lift mechanism operate such that the container is placed on the support table after the support table is placed under the container. According to the above configuration, control of a series of operations of the lift mechanism and the support table enables the inactive gas smoothly to be supplied from the storage into the container after the container is gripped.

The support table may include a restriction member to restrict vertical movements of the container. According to the above configuration, during transport of the container (during supply of inactive gas into the container), the container is prevented from jumping up from the support table, thus stabilizing a connection condition between the inlet of the container and the nozzle fixed on the support table.

### Advantageous Effects of Invention

According to an aspect of the disclosure, a transport vehicle system capable of efficiently supplying inactive gas into a container being transported can be provided.

### Brief Description of the Drawings

FIG. 1 shows an overhead transport vehicle system according to a preferred embodiment of the present disclosure.
FIG. 2 shows a lock mechanism provided at a support table.
FIG. 3 shows a situation that inactive gas is supplied into the overhead transport vehicle from a gas supply device.
FIG. 4 is a flow chart showing an example of operations of the overhead transport vehicle.
FIG. 5 is a flow chart showing an example of operations of the overhead transport vehicle from gripping FOUP to unloading FOUP.
FIG.6 (a) and (b) shows loading operations of the overhead transport vehicle.
FIG.7 (a) and (b) shows loading operations of the overhead transport vehicle.

### Detailed Description of the Preferred Embodiments

Hereinafter, with reference to the attached drawings, a preferred embodiment of the present disclosure will be now described in detail. In the description of the drawings, the same elements will be denoted by the same reference symbols, without redundant description.

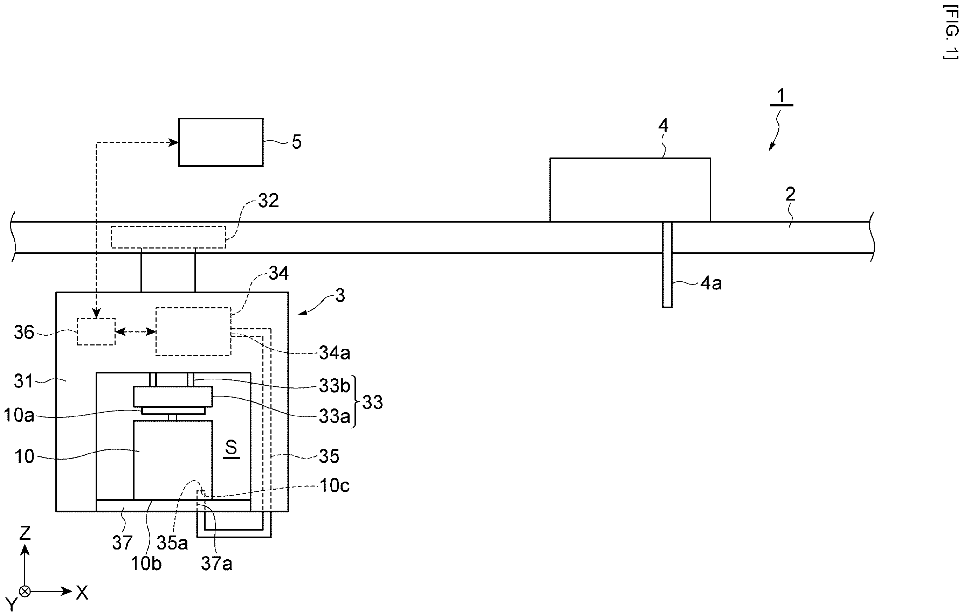

FIG. 1 shows an overhead transport vehicle system according to a preferred embodiment of the present disclosure. As described in FIG. 1, an overhead transport vehicle system 1 (transport system) includes a travel rail 2 (rail), an overhead transport vehicle 3 (transport vehicle), a gas supply device 4, and an upper controller 5. The travel rail 2 is provided at a position (e.g. a ceiling of clean room) higher than a floor. The overhead transport vehicle 3 travels on the travel rail 2. For example, the overhead transport vehicle 3 transports an article such as a FOUP 10 (container) or reticle pod between a storage facility and a predetermined load port. Generally, the overhead transport vehicle system 1 includes a plurality of the overhead transport vehicles 3. In the present preferred embodiment, however, one of these overhead transport vehicles 3 will be described in focus.

A plurality of semiconductor wafers are accommodated in the FOUP 10 having a flange 10a to be gripped by the overhead transport vehicle 3. An inlet 10c that communicates between the inside (in the present embodiment, the inside of a storage room accommodating a plurality of semiconductor wafers) and the outside of the FOUP 10 is provided at a bottom 10b of the FOUP 10.

Hereinafter, for explanatory convenience, a direction (a left-right direction of FIG. 1) along the travel rail 2 is referred to as X axis direction, a perpendicular direction (a vertical direction of FIG. 1) is referred to as Z axis direction, and a direction (a depth direction of FIG.1) orthogonal to both of X axis direction and Z axis direction is referred to as Y axis direction. X axis direction is also a travel direction of the overhead transport vehicle 3. Y axis direction is also a width direction of the overhead transport vehicle 3.

As shown in FIG. 1, the overhead transport vehicle 3 includes a body 31, a travel unit 32, a lift mechanism 33, a tank 34 (storage), a gas supply tube 35, a controller 36, and a support table 37. FIG. 1 shows the overhead transport vehicle 3 that transports the FOUP 10 while inactive gas is supplied into the FOUP 10.

The body 31 is provided below the travel rail 2. The travel unit 32 is a member such as a roller traveling along the travel rail 2. The body 31 is suspended and supported simultaneously by the travel unit 32. A storage space S is formed within the body 31 to store the FOUP 10. In the present preferred embodiment, as an example, the body 31 includes a pair of walls that covers the front and rear sides of the FOUP 10 (both sides of the FOUP 10 in X axis direction) . The storage space S is formed between the pair of walls.

The lift mechanism 33 includes a gripper 33a that grips the flange 10a of the FOUP 10 and a single of or a plurality of belts (e.g. four belts) 33b connected to the gripper 33a and moving up and down with respect to the body 31. The lift mechanism 33 rolls up and reels out the belt 33b so as to move the gripper 33a up and down, thereby, moving the FOUP 10 held by the gripper 33a up and down.

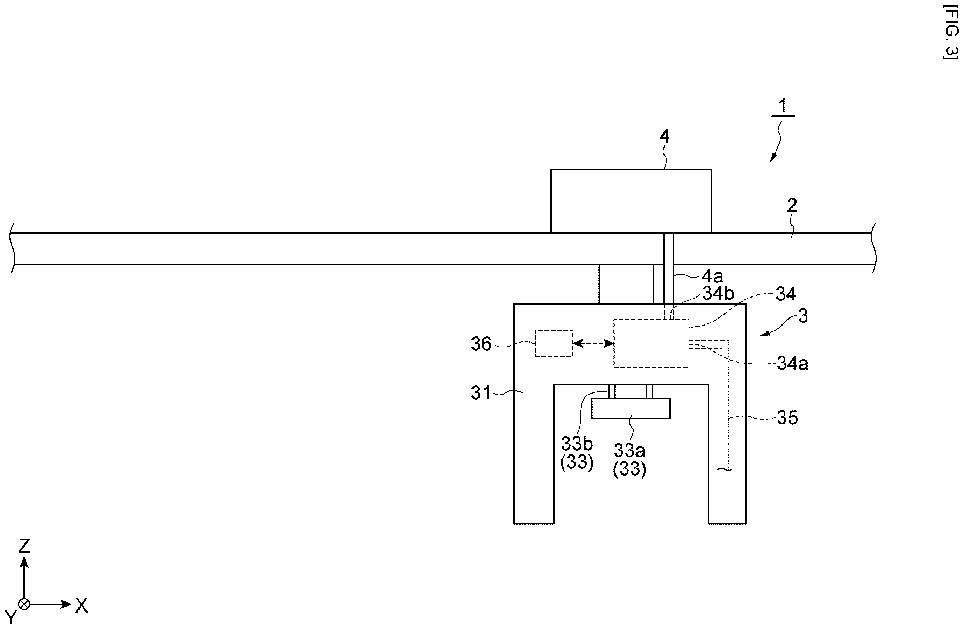

The tank 34 stores inactive gas such as nitrogen gas. The tank 34 is, e.g. a gas cylinder that stores compressed inactive gas. The tank 34 includes an outlet 34a to emit inactive gas outside from the tank 34 and a supply port 34b (see FIG.3) to supply (supplement) inactive gas into the tank 34.

The gas supply tube 35 is a hollow tubular member that is connected with the outlet 34a of the tank 34 to circulate inactive gas from tank 34. A nozzle 35a is provided at an end (top end) of the gas supply tube 35 which is opposite to an end thereof connected with the tank 34. The nozzle 35a is connected with an inlet 10c of the FOUP 10. Inactive gas emitted from the outlet 34a of the tank 34 is supplied into the FOUP 10 via the gas supply tube 35, the nozzle 35a, and the inlet 10c. The inactive gas filled in the FOUP 10 slowly leaks outside from any tiny space of the FOUP 10. Therefore, a consecutive supply of inactive gas into the FOUP 10 is required in order to maintain the FOUP 10 appropriately filled with the inactive gas. Inactive gas is consecutively supplied into the FOUP 10 from the tank 34 through the above gas supply tube 35. Aside from the inlet 10c, an exhaust port (not illustrated) to appropriately control gas pressure within the FOUP 10 may be provided at the FOUP 10.

The controller 36 is an electronic control unit composed of computers with a processor such as CPU and a memory such as ROM or RAM. The controller 36 controls operations of the overhead transport vehicle 3. The controller 36 is capable of communicating over a radio with the upper controller 5 that outputs a transport command (e.g. a traveling command including information on a loading location and unloading location) to the overhead transport vehicle.

The controller 36 includes a sensor or the like to monitor conditions of inactive gas (such as amount (remaining amount) of gas, or gas pressure) stored in the tank 34. As an example, the controller 36 judges whether supply (supplement) of inactive gas into the tank 34 is required or not on a basis of the conditions of the inactive gas in the tank 34. For example, if the controller 36 detects that amount and/or gas pressure of inactive gas in the tank 34 is less than the predetermined threshold, the controller 36 determines the supply of inactive gas into the tank 34 to be required.

If the supply of inactive gas into the tank 34 is determined to be required, as an example, the controller 36 notifies the upper controller 5 of information showing that effect. The upper controller 5 determines the most suitable gas supply device 4 on the basis of a location of the overhead transport vehicle 3 from which the information is notified or a scheduled travel route of the overhead transport vehicle 3 (e.g. a travel route according to a transport command issued to the overhead transport vehicle 3). For example, the upper controller 5 determines a gas supply device closest to an actual location of the overhead transport vehicle 3 or to the scheduled travel route of the overhead transport vehicle 3 to be the most suitable gas supply device 4. The upper controller 5 notifies the controller 36 included in the overhead transport vehicle 3 of a travel command to travel toward the determined gas supply device 4 and the controller 36 controls operations of the overhead transport vehicle 3 to travel up to a position where the gas supply device 4 is located.

The division of roles between the controller 36 and the upper controller 5 is not limited to the above examples. In the above example, the controller 36 judges whether supply of inactive gas into the tank 34 is required or not, however, the upper controller 5 may make this judgment. For example, the controller 36 informs the upper controller 5 of information on gas amount and/or gas pressure of inactive gas in the tank 34, and the upper controller 5 may make the above judgment based on the information. In the above example, the controller 36 and the upper controller 5 control a travel to the gas supply device 4, however, the above-described function of the upper controller 5 may be incorporated in the controller 36. In other words, the controller 36 included in the overhead transport vehicle 3 may autonomously carry out the above control. With this configuration, the upper controller 5 can be omitted.

The support table 37 is a member to support a bottom 10b of the FOUP 10 while the FOUP 10 is transported (while inactive gas is supplied into the FOUP 10). As an example, the support table 37 is formed in a flat plate shape. The support table 37 enables the nozzle 35a to be fixed at a position corresponding to the inlet 10c of the FOUP 10. As an example in the present preferred embodiment, an insertion hole 37a is formed on the support table 37 at the position which overlaps with the inlet 10c seen from Z axis direction. An end portion of the gas supply tube 35 (a position at which the nozzle 35a is located) is inserted into and fixed to the insertion hole 37a. Therefore, the nozzle 35a inserted into and fixed to the insertion hole 37a is located at a position facing the inlet 10c of the FOUP 10 in Z axis direction. The FOUP 10 is placed on the support table 37 and a load of the FOUP 10 is applied to the support table 37, so that the inlet 10c is closely attached to and connected with the nozzle 35a.

As shown in FIG. 1, the support table 37 is located at a support position at which the bottom 10b of the FOUP 10 is supported during transport of the FOUP 10. The support position is a position which is below the FOUP 10 and the lift mechanism 33 and overlaps with the inlet 10 seen from Z axis direction. If the support table 37 is fixed at the support position, the support table 37 interferes with the lift mechanism 33 or the FOUP 10 suspended by the lift mechanism 33 during vertical operations performed by the lift mechanism 33. In order to solve this problem, the support table 37 is configured to be capable of retreating to a retreat position that prevents the support table 37 from interfering with the lift mechanism 33 or the FOUP 10 during vertical operations performed by the lift mechanism 33. That is to say, the support table 37 is capable of switching between a support state and a retreat state. The support state is a state in that the support table 37 is located at the support position so as to support the bottom 10b of the FOUP 10 being transported. The retreat state is a state in that the support table 37 is located at the retreat position not to interrupt vertical operations performed by the lift mechanism 33.

For example, the support table 37 can be configured to be capable of sliding in a travel direction (X axis direction) or a width direction (Y axis direction) of the overhead transport vehicle 3. With this configuration, a position to which the support table 37 slides from the support position in X axis direction or Y axis direction (a position not overlapping with the lift mechanism 33 and the FOUP 10 seen from Z axis direction) is the above described retreat position. With this configuration, the support table 37 can switch between the support state and the retreat state by sliding horizontally. However, an aspect of movements of the support table 37 between the support position and the retreat position and the retreat position are not limited to the above embodiment. For example, the support table 37 may be capable of turning around X axis or Y axis. With this configuration, the support table 37 can be located along XZ plane or YZ plane at a side of the storage space S in the retreat state. In addition, the support table 37 may be foldable. With this configuration, the support table 37 may be folded and located at a side of the storage space S in the retreat state. Further, the nozzle 35a has only to be fixed to the support table 37 at least in the support state. The nozzle 35a may be removed from the support table 37 in the retreat state.

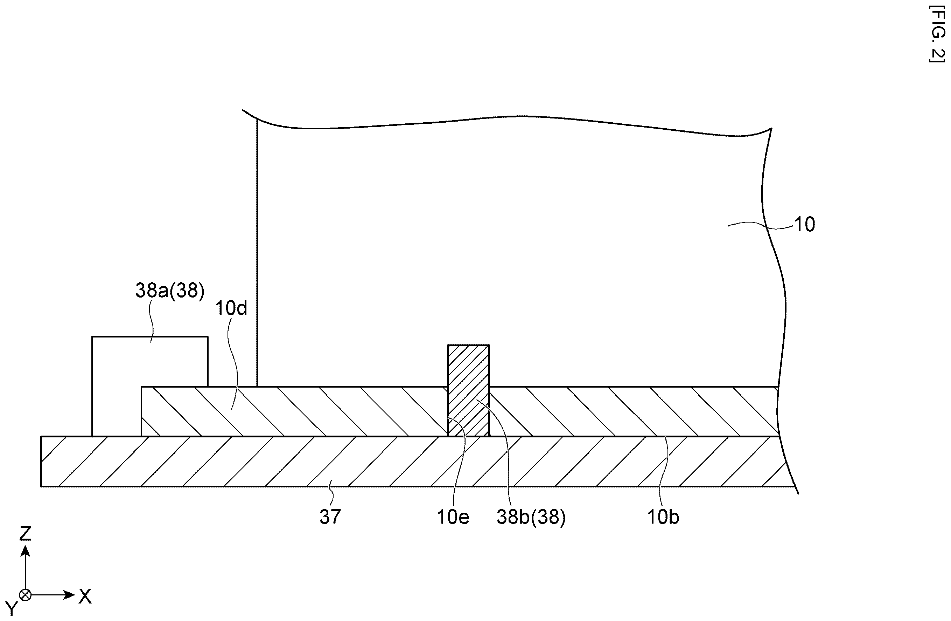

As shown in FIG. 2, the support table 37 includes a lock mechanism 38 to restrict movements of the FOUP 10 with respect to the support table 37. The lock mechanism 38 has a claw 38a (restriction member) to restrict vertical movements (in Z axis direction) of the FOUP 10 and a pin 38b to restrict horizontal movements (in X axis direction or Y axis direction) of the FOUP 10.

As an example, the FOUP 10 has a bottom flange 10d including the above bottom 10b and protruding in X axis direction or Y axis direction. The claw 38a is formed in a hooked shape and abuts a top surface and a side surface of an edge of the bottom flange 10d. As shown in FIG. 2, the bottom flange 10d is held between the claw 38a and the support table 37, so that the bottom flange 10d is prevented from jumping up from the support table 37 ( from moving in a vertical direction of the FOUP 10). For example, the claw 38a is configured to detect that the FOUP 10 is placed on the support table 37 (a load of the FOUP 10 is applied) and lock the bottom flange 10d as shown in FIG. 2. In addition, when vertical operations are performed by the lift mechanism 33 for unloading operations, for example, on a basis of a release signal from the controller 36, the claw 38a releases the locked state to change the support table 37 into the retreat state.

The claw 38a may be provided at one position or a plurality of positions. For example, the claw 38a may be provided at two positions located diagonally to the rectangular or substantially rectangular support table 37 seen from Z axis direction or at four corners of the support table 37. When the claw 38a is provided at a plurality of positions, horizontal movements of the FOUP 10 are also restricted by the claw 38a.

Generally, a plurality of positioning holes (e.g. three holes) 10e are formed on the bottom flange 10d of the FOUP 10. The pin 38b is provided at a position corresponding to the positioning hole 10e. Thus the pin 38b is inserted in the positioning hole 10e while the FOUP 10 is placed on the support table 37. Therefore, the horizontal movements of the FOUP 10 with respect to the support table 37 are restricted also by the pin 38b.

The gas supply device 4 is intended to supply inactive gas into the tank 34 of the overhead transport vehicle 3. The gas supply device 4 is provided along the travel rail 2 so as not to prevent the overhead transport vehicle 3 from traveling along the travel rail 2. The gas supply device 4 may be installed directly on the travel rail 2 or on another member (e.g. a ceiling) disposed close to the travel rail 2. The overhead transport vehicle system 1 may include a single one of the gas supply device 4 or a plurality of the gas supply devices 4.

The gas supply device 4 stores inactive gas to be supplied into the overhead transport vehicle 3 and is capable of supplying the inactive gas into the tank 34 of the overhead transport vehicle 3 located at a predetermined position of the travel rail 2 (in the present embodiment, a position below the gas supply device 4). In other words, the gas supply device 4 functions as a station to supply inactive gas into the overhead transport vehicle 3. Hereinafter, the above-described predetermined position is referred to as 'gas supply position'.

FIG. 3 shows that inactive gas is supplied into the overhead transport vehicle 3 from the gas supply device 4. The gas supply device 4 supplies inactive gas into the tank 34 of the overhead transport vehicle 3 while the overhead transport vehicle 3 is at a stop on a gas supply position. As an example, the gas supply device 4 has a gas supply tube 4a that circulates inactive gas from a supply source (not illustrated) . When detecting that the overhead transport vehicle 3 stops at the gas supply position, the gas supply device 4 controls the gas supply tube 4a to connect a connection port (end portion) of the gas supply tube 4a to the supply port 34b of the tank 34, thus supplying the inactive gas from the supply source of the gas supply device 4 into the tank 34 via the gas supply tube 4a and the supply port 34b. FIG. 3 shows an example of the overhead transport vehicle 3 without the FOUP 10 transported, however, the gas supply device 4 may supply inactive gas into the overhead transport vehicle 3 that is transporting the FOUP 10.

For example, inactive gas is supplied from the gas supply device 4 into the tank 34 of the overhead transport vehicle 3 as follows. From the controller 36 of the overhead transport vehicle 3 located at a gas supply position, the gas supply device 4 receives a supply request signal including information on required amount of gas to be supplied. The reception of the supply request signal triggers the gas supply device 4 to perform the above gas supply operations (i.e. the connection of the gas supply tube 4a to the supply port 34b, and the supply of the inactive gas). When completing to supply the above required amount of gas, the gas supply device 4 notifies the controller 36 of the completion of gas supply as well as releases the connection between the gas supply tube 4a and the supply port 34b of the tank 34, thus releasing the connection between the overhead transport vehicle 3 and the gas supply device 4 and allowing the overhead transport vehicle 3 to move along the travel rail 2.

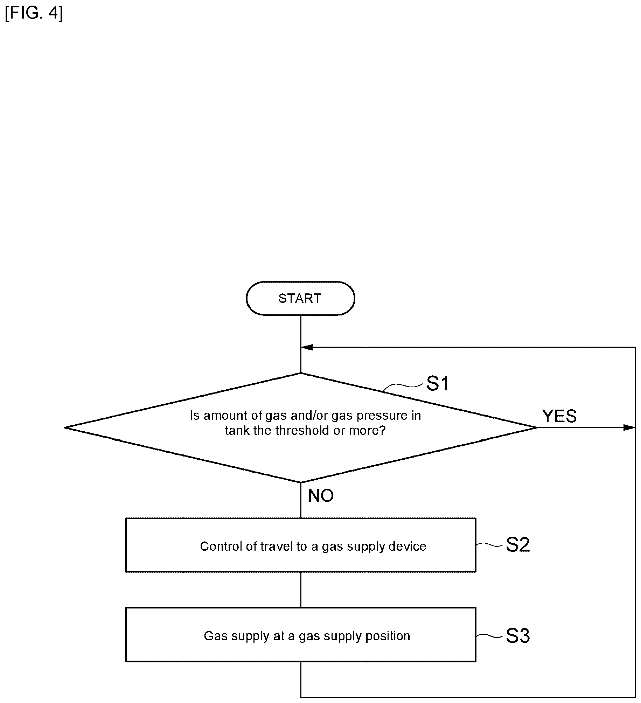

With reference to the flow chart shown in FIG.4, an example of performance of the overhead transport vehicle system 1 will be now described. As shown in FIG. 4, the controller 36 of the overhead transport vehicle 3 continuously monitors conditions (in the present embodiment, amount of gas and gas pressure) of inactive gas in the tank 34(step S1). while the amount of gas and gas pressure in the tank 34 is equal to or more than a predetermined threshold ('Yes' at step S1), the controller 36 continues to monitor as above travels along the travel rail 2 and simultaneously transports the FOUP 10 on a basis of a command from the upper controller 5.

Meanwhile, in detecting that the amount of gas and gas pressure in the tank 34 is less than the threshold ('No' at step S1), the controller 36 controls a travel to the gas supply device 4 (i.e. the gas supply position to be supplied with a gas by the gas supply device 4) (step S2). As described above, in the present preferred embodiment, the controller 36 notifies the upper controller 5 that supply of inactive gas into the tank 34 is required, and then, on the basis of the subsequent command from the upper controller 5, the controller 36 causes the overhead transport vehicle 3 to travel to the designated gas supply position. The above operations of inactive gas supply are performed after the overhead travel vehicle 3 arrives at the gas supply position (step S3).

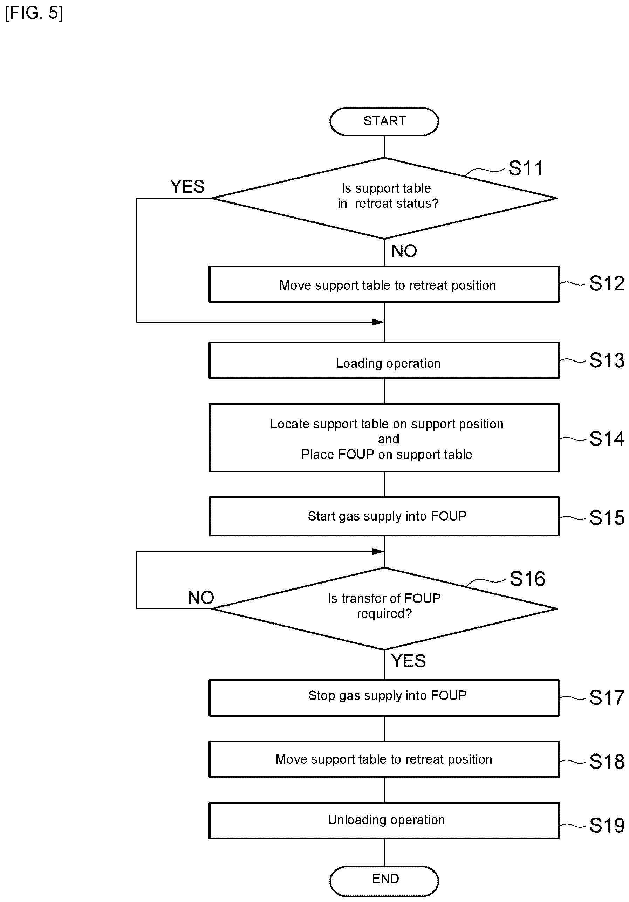

With reference to the flow chart shown in FIG.5, an example of operations of the overhead transport vehicle 3 (controller 36) from gripping to unloading the FOUP 10 will be now described. Here, operations to grip the FOUP 10 located below the overhead transport vehicle 3 are described. The controller 36 checks whether the support table 37 is in a retreat state or not (whether the support table 37 is located at the retreat position or not) (step S11). If the support table 37 is in the retreat state ('Yes' at step S11), it goes forward to step S13. If the support table 37 is not in the retreat state ('No' at step S11), or if the support table 37 is located at a support position (below the lift mechanism 33), the controller 36 moves the support table 37 to the retreat position (step S12), thus allowing the lift mechanism 33 to descend so as to grip the FOUP 10 located below the overhead transport vehicle 3. The above operations of steps S11 and S12 are just for safety and not necessary. In particular, a correct completion of previous unloading operations ensures that the support table 37 is in the retreat state. Accordingly, if a correct completion of previous unloading operations has been confirmed, steps S11 and S12 may be skipped.

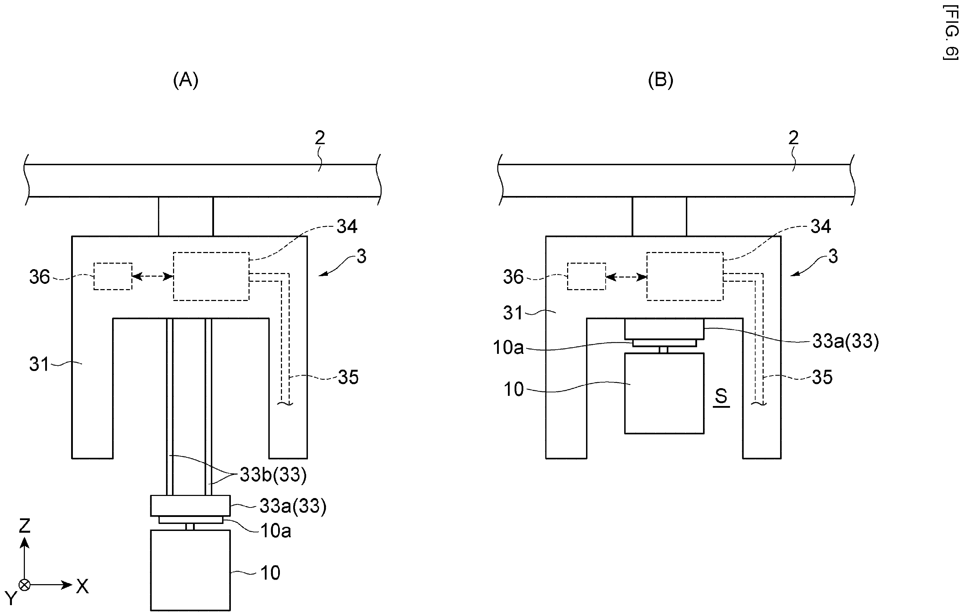

The controller 36 performs a loading operation of the FOUP 10 to be transferred (step S13). The controller 36 reels out the belt 33b to move the lift mechanism 33 down and causes the gripper 33a to grip a flange 10a of FOUP 10 to be transferred (see FIG. 6(A)). Then the controller 36 rolls up the belt 33b to move the lift mechanism 33 up and stores the FOUP 10 into the storage space S (see FIG. 6(B)).

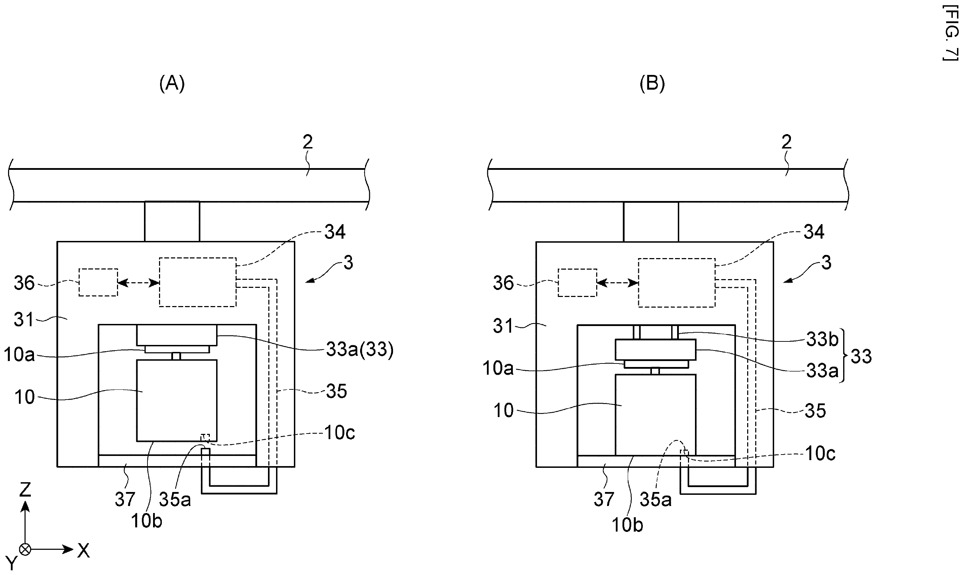

The controller 36 makes the support table 37 become in a support state (see FIG.7 (A)) and places the FOUP 10 on the support table 37 (see FIG.7 (B)) (step S14). As shown in FIG. 7 (A), after the support table 37 is placed at the support position, the belt 33b is reeled out, so that the lift mechanism 33 is moved down, thus enabling a load of the FOUP 10 to be applied on the support table 37 as shown in FIG.7 (B). Thus, the bottom 10b of the FOUP 10 is supported by the support table 37. The gripper 33a may release the gripped flange 10a so that the load of the FOUP 10 can be appropriately applied to the support table 37, thus allowing the inlet 10c of the FOUP 10 and the nozzle 35a fixed to the support table 37 to be connected with each other. At the same time, the bottom flange 10d of the FOUP 10 is locked by the lock mechanism 38 as shown in FIG. 2.

Inactive gas stored in the tank 34 starts to be supplied into the FOUP 10 via the gas supply tube 35, the nozzle 35a, and the inlet 10c (step S15). The overhead transport vehicle 3 travels on the travel rail 2 with supplying the inactive gas from the tank 34 into the FOUP 10 until transfer of the FOUP 10 becomes required('No' at step S16). For example, upon detecting that the overhead transport vehicle 3 arrives at an unloading position where the FOUP 10 is unloaded or a position within a predetermined distance from the unloading position, the controller 36 determines that transfer (unloading operation) of the FOUP 10 is required ('Yes' at step S16). The controller 36 stops the supply of the inactive gas into the FOUP 10 from the tank 34 in order to unload the FOUP 10 (step S17), and the controller 36 makes the support table 37 become in the retreat state as shown in FIG. 6(B) (step S18). Then, the controller 36 performs unloading operations of the FOUP 10 as follows. The controller 36 reels out the belt 33b to move the lift mechanism 33 down and place the FOUP 10 at the unloading position such as a storage shelf, and then release the flange 10a gripped by the gripper 33a. Thus, the unloading operation of the FOUP 10 is completed.

In the above-described overhead transport vehicle system 1, the overhead transport vehicle 3 includes the tank 34 to supply inactive gas into the FOUP 10 being transported, thus enabling inactive gas to be consecutively supplied into the FOUP 10 during transport of the FOUP 10 and maintaining appropriately the FOUP 10 filled with the inactive gas. Further, in the overhead transport vehicle system 1, the gas supply device 4 to supply interactive gas into the tank 34 is provided along the travel rail 2 on which the overhead transport vehicle 3 travels, thus allowing inactive gas to be supplied (supplemented) easily and appropriately into the tank 34 included in the overhead transport vehicle 3. For example, the overhead transport vehicle 3 travels along the travel rail 2 up to a position (gas supply position) where the gas supply device 4 is located, and supplements inactive gas before the tank 34 runs out of inactive gas, thereby maintaining appropriately the inactive gas stored in the tank 34. As a result, according to the overhead transport vehicle system 1, supply of the inactive gas into the FOUP 10 being transported can be efficiently maintained.

Further, the overhead transport vehicle system 1 includes a controller (in the present embodiment, the controller 36 and the upper controller 5). The controller monitors conditions of interactive gas stored in the tank 34 and judges whether supply of the interactive gas into the tank 34 is required or not on the basis of the conditions of the inactive gas stored in the tank 34. If the gas supply is determined to be required, the controller makes the overhead transport vehicle 3 travel up to a gas supply position. According to the above configuration, monitoring inactive gas in the tank 34 and supplementing inactive gas into the tank 34 can be automatized by the controller, thus allowing the tank 34 of the overhead transport vehicle 3 to be appropriately prevented from running out of inactive gas. According to the above configuration, time and effort to check a remaining amount of inactive gas in the tank 34 of the overhead transport vehicle 3 or to exchange the tank 34 manually can be saved as well as a lack of gas in the tank 34 can be prevented appropriately.

The overhead transport vehicle 3 includes the gas supply tube 35, the nozzle 35a, and the support table 37. The gas supply tube 35 is connected with the tank 34 and circulates inactive gas. The nozzle 35a is provided at an end portion of the gas supply tube 35 and connected to the inlet 10c provided on the bottom 10b of the FOUP 10 to supply inactive gas into the FOUP 10. The support table 37 on which the nozzle 35a can be fixed to the position corresponding to the inlet 10c of the FOUP 10, supports the bottom 10b of the FOUP 10. According to the above configuration, the FOUP 10 is supported by the support table 37 and load of the FOUP 10 is applied to the support table 37, so that the inlet 10c of the FOUP 10 and the nozzle 35a fixed on the support table 37 can be closely connected. Therefore, inactive gas in the tank 34 can be supplied stably into the FOUP 10 via the gas supply tube 35, the nozzle 35a, and the inlet 10c.

The overhead transport vehicle 3 further includes the body 31 into which the FOUP 10 is stored during transport of the FOUP 10 and the lift mechanism 33 which is capable of suspending the FOUP 10 and moves the FOUP 10 up and down with respect to the body 31. The support table 37 is capable of retreating to the retreat position that prevents the support table 37 from interfering with the lift mechanism 33 or the FOUP 10 suspended by the lift mechanism 33 at least during vertical operations performed by the lift mechanism 33. According to the above configuration, the support table 37 is capable of retreating to the retreat position, so that transfer (loading and unloading) operations of the FOUP 10 involving vertical operations performed by the lift mechanism 33 can be performed appropriately.

The overhead transport vehicle 3 stores the FOUP 10 in the body 31 by causing the lift mechanism 33 to grip and move up the FOUP 10 while the support table 37 is located at the retreat position(steps S11 to S13 in FIG. 5). After the FOUP 10 is stored in the body 31, the overhead transport vehicle 3 places the support table 37 below the FOUP 10 (the support position) from the retreat position (see FIG. 7(A)). After the support table 37 is placed below the FOUP 10, the overhead transport vehicle 3 causes the lift mechanism 33 to operate such that the FOUP 10 is placed on the support table 37(see FIG.7(B)). According to the above configuration, by controlling a series of operations of the lift mechanism 33 and the support table 37, the overhead transport vehicle 3 enables smoothly inactive gas to be supplied from the tank 34 into the FOUP 10 after the FOUP 10 is gripped.

The support table 37 includes the claw 38a that restrains vertical movements of the FOUP 10. With the above configuration, during transport of the FOUP 10 (during supply of inactive gas into the FOUP 10), the FOUP 10 is prevented from jumping up with respect to the support table 37, thus allowing a connection condition between the inlet 10c of the FOUP 10 and the nozzle 35a fixed to the support table 37 to be stabilized.

The preferred embodiments of the present disclosure was described as above, however, the disclosure is not limited to the above embodiments. For example, the upper controller 5, which issues a transport command (transport of the FOUP 10 from a first point to a second point) to an overhead transport vehicle 3, is capable of performing each transport control on the basis of the conditions of the inactive gas (amount of gas and/or gas pressure) in the tank 34. For example, the upper controller 5 may determine an overhead transport vehicle 3 to which the transport command is issued on the basis of a remaining amount of inactive gas in the tank 34 of each of a plurality of the overhead transport vehicles 3 arranged in the overhead transport vehicle system 1 and a transport distance according to the transport command. For example, the upper controller 5 may determine to issue the transport command to the overhead transport vehicle 3 including the tank 34 storing enough amount of inactive gas to prevent the tank 34 from running out of the gas during transport of the FOUP 10. With the configuration, the tank 34 can be prevented from running out of the gas during transport of the FOUP 10, thus enabling oxidations of semiconductor wafers in the FOUP 10 to be prevented appropriately. As described above, inactive gas can be supplied into the tank 34 by the gas supply device 4 even during transport of the FOUP 10, however, the transport of the FOUP 10 is delayed for the time required for the gas supply. According to the above issuance control, any supply of inactive gas from the gas supply device 4 during the transport of the FOUP 10 is not required. Therefore, the delay of transport of the FOUP 10 can be prevented.

The above preferred embodiment showed an example of the overhead transport vehicle 3 that transfers the FOUP 10 vertically with the lift mechanism, however, the overhead transport vehicle 3 may be configured to be capable of transferring the FOUP 10 horizontally (Y axis direction). If the overhead transport vehicle 3 is a dedicated vehicle for horizontal transfer, the support table 37 does not need to be retreated during transfer operations (during loading or unloading operations) of the FOUP 10. That is to say, the support table 37 may be fixed at the above support position.

The above preferred embodiment, as an example of the transport vehicle system, showed the overhead transport vehicle system 1 including a plurality of the overhead transport vehicles. The overhead transport vehicle included in the transport vehicle system may be a vehicle traveling on a rail, for example, it may be a vehicle traveling on a rail laid on the ground.

### Reference Signs List

1: Overhead transport vehicle system (transport vehicle system)
2: Travel rail (rail)
3: Overhead transport vehicle (transport vehicle)
4: Gas supply device
5: Upper controller (controller)
10: FOUP (container)
10b: Bottom
10c: Inlet
31: Body
33: Lift mechanism
34: Tank (storage)
35a: Nozzle
36: Controller
37: Support table
38a: Claw (restriction member)

## Claims

1. A transport vehicle system, comprising:
a rail;
a transport vehicle traveling on the rail to transport a container, the transport vehicle including a storage storing inactive gas and supplying the inactive gas from the storage into the container being transported; and
a gas supply device provided along the rail and supplying the inactive gas into the storage of the transport vehicle.

2. The transport vehicle system according to claim 1, further comprising a controller configured to monitor conditions of the inactive gas stored in the storage and judge whether supply of the inactive gas into the storage is required or not on a basis of the conditions of the inactive gas, the controller configured to control the transport vehicle to travel up to a position where the gas supply device is located if supply of the inactive gas is determined to be required.

3. The transport vehicle system according to any of claims 1 or 2, wherein the transport vehicle comprising:
a gas supply tube connected with the storage to circulate the inactive gas;
a nozzle provided at an end portion of the gas supply tube and connected to an inlet provided on a bottom of the container to supply the inactive gas into the container; and
a support table supporting the bottom of the container and being capable of fixing the nozzle at a position corresponding to the inlet of the container.

4. The transport vehicle system according to claim 3,
wherein the transport vehicle further includes a body into which the container is stored during transport of the container and a lift mechanism configured to be capable of suspending the container and move vertically with respect to the body,
wherein the support table is capable of retreating to a retreat position that prevents the support table from interfering with the lift mechanism and the container suspended by the lift mechanism at least when vertical operations are performed by the lift mechanism.

5. The transport vehicle system according to claim 4,
wherein the transport vehicle is configured:
to make the lift mechanism grip and lift up the container to store the container into the body in a state where the support table is retreated to the retreat position;
to cause the support table to be placed under the container from the retreat position after the container is stored into the body; and
to make the lift mechanism operate such that the container is placed on the support table after the support table is placed under the container.

6. The transport vehicle system according to any of claims 3 to 5,
wherein the support table includes a restriction member to restrict vertical movements of the container.
